# EUROPEAN PATENT SPECIFICATION

(11) **EP 1 804 166 B1**
(45) Date of publication and mention of the grant of the patent: **23.07.2008**
(21) Application number: 06025260.8
(22) Date of filing: 06.12.2006
(51) Int. Cl.: G11C 29/00, G06F 11/20

(54) **Memory device and information processing apparatus**
Speichervorrichtung und Informationsverarbeitungsvorrichtung
Dispositif de mémoire et appareil de traitement des informations

(30) Priority: 27.12.2005 JP 2005376686
(43) Date of publication of application: 04.07.2007
(73) Proprietor: MegaChips Corporation, Yodogawa-ku Osaka-shi (JP)
(72) Inventor: Kawamura, Atsufumi, Yodogawa-ku Osaka-shi Osaka 532-0003 (JP)
(74) Representative: Winter, Brandl, Fürniss, Hübner Röss, Kaiser, Polte Partnerschaft Patent- und Rechtsanwaltskanzlei

(56) References cited:
- US-A1- 2005 141 300
- US-B1- 6 742 078

## Description

### BACKGROUND OF THE INVENTION

### Field of the Invention

The present invention relates to a technique to store a file into a memory device.

### Description of the Background Art

With an increase in capacity of memories, memories in each of which a defective area exists in part of its memory area (these memories are hereinafter referred to as "non-perfect memories") have been widely used.

In general, such a memory needs replacement for the defective area on a page-by-page basis, and its information (replacement page information) is stored in part of the memory area of the memory. The replacement page information is information on which page is defective and with which page the defective page is replaced.

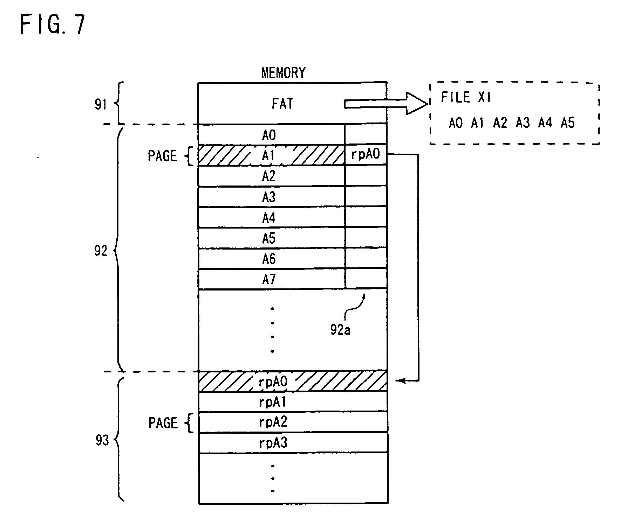

Fig. 7 is a view showing a memory in which replacement page information is stored in part of its memory area. This memory comprises a file management information area 91, a data area 92 and a reserve area 93. As shown in Fig. 7, the data area 92 and the reserve area 93 are managed by areas on a page-by-page basis. In the file management information area 91, a FAT (File Allocation Table) is recorded. The FAT manages chain information on a file stored in the data area 92. In other words, one file is stored in a plurality of page areas in the data area 92 and the chain information of pages in which the file is stored is recorded in the FAT.

For example, it is assumed that a file X1 is stored in six page areas having page addresses A0 to A5. In this case, the chain information of the pages A0 → A1 → A2 → A3 → A4 → A5 is recorded in the FAT as storage information of the file X1. With this, a file system refers to the FAT to read out the file.

In each memory area of the data area 92, an replacement information storage area 92a is provided. If a memory area of the data area 92 is a defective area, the address information of the reserve area 93 is recorded in a replacement information storage area 92a corresponding to the defective area. With this, even if there is a defective area in the data area 92, by referring to the replacement information storage area 92a, it is possible to read out a file. In Fig. 7, for example, "rpA0" is recorded in the replacement information storage area 92a of the page address A1. Therefore, it can be seen that the page address A1 is a defective area and data to be stored at the page address A1 is stored at the page address rpA0 of the reserve area 93.

In general, if such a memory is used, a system saves the replacement page information in a cache on access to the memory. Then, in reading the file, first, the system refers to the FAT to acquire the chain information of the page addresses, and next refers to the cached replacement page information to check if the page addresses are hit. Thus, with a means to access the file stored in the replacement page equipped as software, a non-perfect memory can be used with low cost.

The above-discussed method, in which the replacement page information is cached and an operation for checking if the pages are hit is performed by software, may arise a problem of overhead of the software operation.

Further, if the addresses become discontinuous after the replacement for the defective part, there arises a problem that the system can not effectively use the high-efficient DMA transfer.

Herein, an exemplary case will be taken for discussion, where the file X1 of Fig. 7 is stored in the memory. First, if the memory is a perfect memory (having no defective area), the file X1 is stored in the continuous areas A0, A1, A2, A3, A4 and A5 in the data area 92. Therefore, with increment of the address, the file X1 can be read out by one DMA transfer.

If the memory is a non-perfect memory, however, and the address A1 is a defective area and replaced with the address rpA0, for reading the file X1 needed are the following three DMA transfers of;
(1) reading the address A0,
(2) reading the address rpA0, and
(3) reading the addresses A2, A3, A4 and A5. In summary, if the file is stored in continuous addresses, it is possible to perform a DMA burst transfer by incrementing the address while if the file is stored in discontinuous addresses, it is necessary to once finish the DMA transfer and cause an interrupt again to perform the next DMA transfer.

If the memory is a non-perfect memory and not only the address A1 is replaced with the address rpA0 but also the address A3 is replaced with the address rpA1, five DMA transfers are needed to read out the file X1.

In terms of efficiencies in development and manufacture, it is preferable to use the same ROM code for the same program. Also in terms of management, it is preferable to use the same ROM code. If a program is stored in a memory by using the same ROM code, however, from the above reason, there arises a problem of causing a difference in performance between the case of using a perfect memory as the memory and the case of using a non-perfect memory.

In order to increase the performance of the system using a non-perfect memory, other than the above method, there may be a method in which all the operations for replacement of pages are performed by hardware. Hardware equipment, however, may cause a problem of higher cost.

Document US 2005/141300 A describes a non-volatile memory which is provided with a replacing function to replace a group of memory cells including defective memory cells which are incapable of normal writing or erasion with a group of memory cells including no defective memory cell. A memory section includes a regular area for storing regular data, an alternative area for storing data alternatively in case of a defect cell, and a management table area including a defect management table. This document relates to a sector-wise replacement of sectors in the memory.

Document US 6 742 078 B relates to a management and link structure of a flash memory. The flash memory is divided into several different types of data access blocks such as general data blocks, spare blocks, link-table blocks, and new blocks. A management and calculating method for spare blocks is provided. The link structure contains a file allocated table.

Therefore, it is an object of the present invention to provide a technique to efficiently access a file stored in a memory having a defective area. It is another object of the present invention to provide a system which causes no difference in performance between the case of using a perfect memory as the memory and the case of using a non-perfect memory.

The object is solved by the features of independent claim 1. The dependent claims are directed to preferred embodiments of the invention.

By the present invention, since it becomes possible for the file system to acquire replacement information, the replacement information is processed in the earlier step of the operation for accessing a file and this ensures an increase in efficiency of file access.

The information processing apparatus of the present invention can efficiently access even a file stored in discontinuous areas due to presence of a defective area.

The above and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a block diagram of an information processing apparatus in accordance with a preferred embodiment of the present invention;
Fig. 2 is a view showing a functional hierarchy of the information processing apparatus;
Fig. 3 is a view showing a state where a file is stored in a memory having a defective area;
Fig. 4 is a flowchart showing an operation for reading a file in accordance with the preferred embodiment;
Fig. 5 is a view showing a state where page indexes are stored in a page index buffer;
Fig. 6 is a view showing an image of command replacement; and
Fig. 7 is a view showing a background-art memory in which replacement information is recorded in part of its memory area.

### DESCRIPTION OF THE PREFERRED EMBODIMENTS

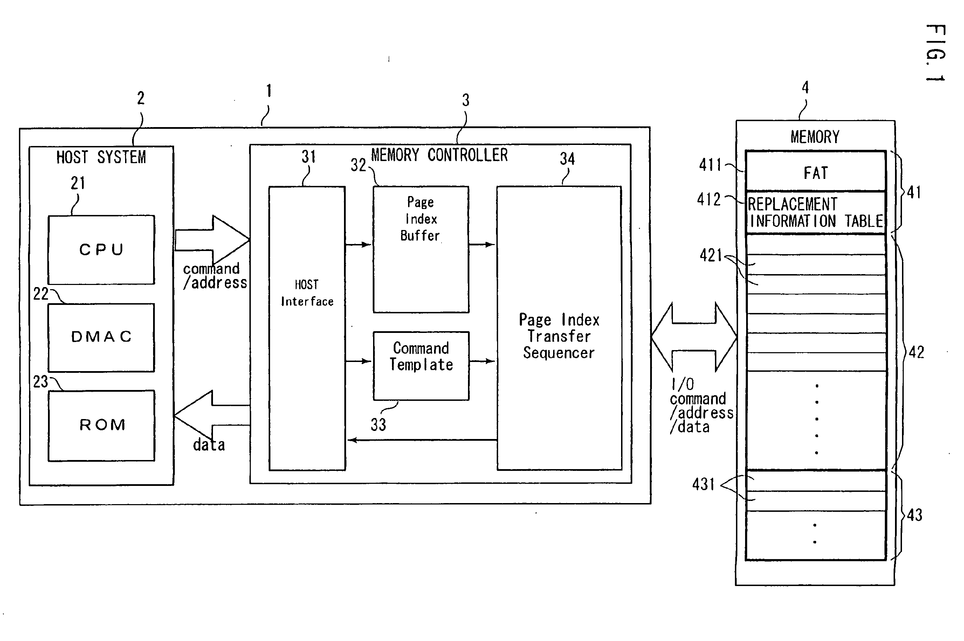

The preferred embodiment of the present invention will be discussed, referring to figures. Fig. 1 is a functional block diagram of an information processing apparatus 1 in accordance with the preferred embodiment of the present invention. The information processing apparatus 1 is an apparatus for reading a file stored in a memory 4 and performing a variety of information processings. In this preferred embodiment, the memory 4 is a semiconductor memory such as a flash memory.

Further, in this preferred embodiment, the information processing apparatus 1 controls the memory 4 with a FAT file system. As shown in Fig. 1, the memory 4 comprises a file management information area 41, a data area 42 and a reserve area 43.

The data area 42 is partitioned into a plurality of page areas 421, in which material substances of program files and data files are stored. Access is made to data in the memory 4 on a page-by-page basis. The reserve area 43 is partitioned into a plurality of page areas 431 and managed on a page-by-page basis. In this preferred embodiment, as the memory 4, an object is a memory in which there may be a defective area in part of storage area. In other words, there may be a defective area in some of the page areas included in the data area 42. If the data area 42 has a defective area, the reserve area 43 is used as the replacement area.

In the file management information area 41, a FAT (File Allocation Table) 411 and a replacement information table 412 are stored. In the FAT 411, storage information of a file is recorded. Specifically, chain information of pages in which the file is stored is recorded. Detailed description will be made later on the replacement information table 412.

The information processing apparatus 1 is, for example, a game device. In this case, the memory 4 corresponds to a game cartridge and the information processing apparatus 1, as the game device, executes a game program stored in the memory 4.

The information processing apparatus 1 comprises a host system 2 and a memory controller 3. The host system 2 is a central processing part for performing a general control on the information processing apparatus 1, and comprises a CPU 21, a DMAC (Direct Memory Access Controller) 22 and a ROM 23. In the ROM 23, various software as described later are stored. Other than those, the information processing apparatus 1 further comprises various input devices, output devices and the like. If the information processing apparatus 1 is a game device, the information processing apparatus 1 comprises a liquid crystal display, a speaker and the like as the output device and comprises various operation buttons as the input device.

The memory controller 3 comprises a host interface 31, a page index buffer 32, a command template generator 33 and a page index transfer sequencer 34.

The host interface 31 is an interface used for inputting and outputting of commands and data to/from the host system 2. In other words, the host interface 31 is an interface used for receiving a read command or a write command specifying an address part from the host system 2 and that used for outputting data read out from the memory 4 to the host system 2.

The page index buffer 32 is a buffer into which page indexes of a file to be read out are stored. In other words, it is a buffer in which information on all the pages where the file to be read out is stored is recorded. As discussed above, the file is stored in a plurality of page areas in the memory 4 and the page indexes are information specifying the page areas in which the file is stored. More specifically, the page indexes are information specifying addresses of the page areas in which the file is stored. As discussed later, the addresses stored in the page index buffer 32 are the physical addresses of the memory 4. If a file is stored in discontinuous pages, discontinuous physical addresses are recorded, without any change, in the page index buffer 32.

The command template generator 33 generates a template for a read command which is generated in the page index transfer sequencer 34. Then, the page index transfer sequencer 34 replaces an address part of a command generated by the command template generator 33 with page indexes which are stored in the page index buffer 32 and outputs page-replaced read commands to the memory 4. The command template generator 33 and the page index transfer sequencer 34 are formed of hardware.

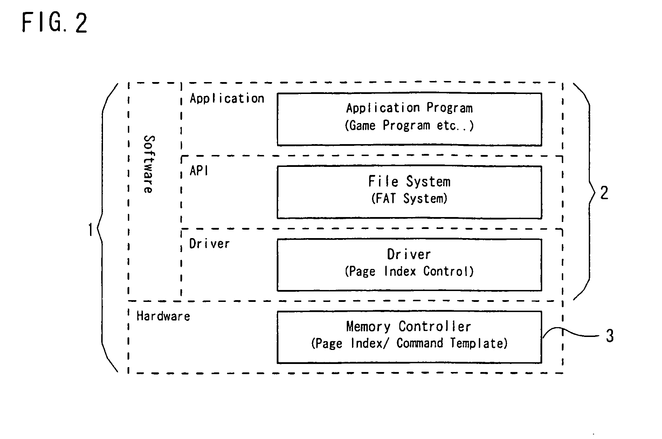

Fig. 2 is a view showing a structure of the information processing apparatus 1 which is separated into a software layer and a hardware layer. As shown in Fig. 2, the software layer consists of an application layer of higher level, an API (Application Program Interface) layer of middle level, lower than the application layer, and a driver layer of lower level, and the hardware layer is located lower than the driver layer. In this preferred embodiment, the application layer corresponds to an application program such as a game program, the API layer corresponds to the FAT system and the driver layer corresponds to a driver (device driver) for controlling the memory controller 3.

The application program is stored in the memory 4. The FAT system is constituted of programs and information, such as tables, recorded in the memory 4 (information stored in the file management information area 41), and the program part is (these programs are) stored in the ROM 23. The drivers are stored in the ROM 23.

Next, description on the replacement information table 412 will be made. As discussed above, the data area 42 of the memory 4 is partitioned into a plurality of page areas 421 and the memory 4 is access-controlled on a page-by-page basis. In other words, a read operation or a write operation for data is performed on a page-by-page basis. Therefore, if one file is divided and stored into a plurality of page areas 421 to be stored, page chain information for each file is recorded in the FAT 411.

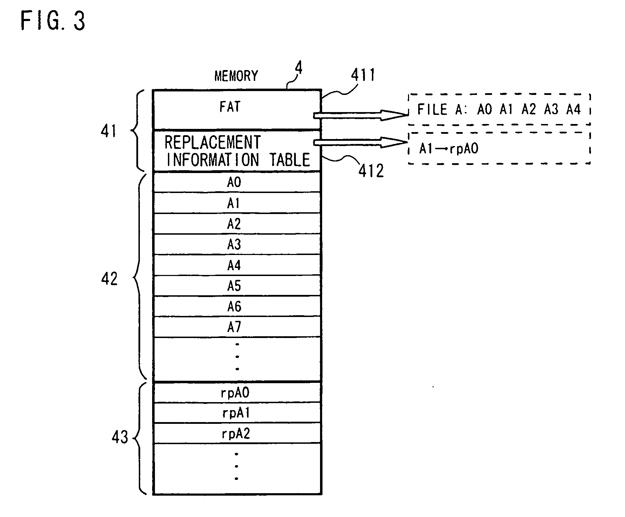

Fig. 3 is a view showing a state where a file A is stored in the memory 4. The file A is stored at five page addresses A0, A1. A2, A3 and A4 in the data area 42. Therefore, chain information on the pages A0 → A1 → A2 → A3 → A4 is recorded in the FAT 411 as storage information of the file A.

In the exemplary case of Fig. 3, it is assumed that the memory area of page address A1 is a defective area. Then, information indicating that the area of page address A1 is a defective area and the address of its replacement area is "rpA0" is recorded in the replacement information table 412.

This replacement information table 412 is an area to which a file system makes access. In this preferred embodiment, this is an area to which the FAT file system makes access. Specifically, when the host system accesses the memory 4, first, the FAT file system reads out the file management information area 41 and at that time, this area is read out together with the FAT 411.

In other words, in the memory 4 of this preferred embodiment, if a defective area exists therein, replacement information is recorded in the replacement information table 412 which is managed by the file system when the file is stored. For this reason, the replacement information can be acquired together with the FAT 411 which is referred to by the file system in the earlier process step of the operation for reading the file, and this ensures an increase in processing efficiency.

Further, in this preferred embodiment, the storage address information indicating an address at which the file is planned to be stored is recorded in the FAT 411 and the replacement information is recorded in the replacement information table 412 separately from the FAT 411. In other words, in the file management information area 41, the chain information on the file in the case of no defective area is recorded in the FAT 411 and information indicating the correspondence information between the defective area and the replacement area is separately recorded in the replacement information table 412. As another preferred embodiment, these information may be recorded as one unified information. Specifically, the chain information on the file after the defective area is replaced with the replacement area may be recorded in the file management information area 41. In the case of Fig. 3, information indicating the chain of addresses A0 → rpA0 → A2 → A3 → A4 may be recorded in the file management information area 41 as the chain information on the file A.

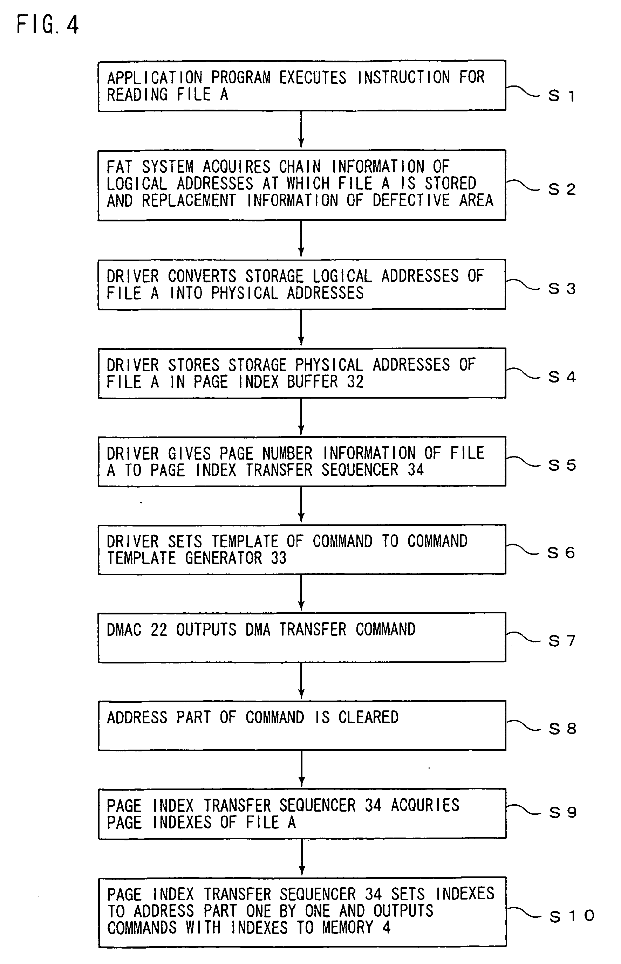

With the above constitution, a flow of memory access operation by the information processing apparatus 1 in this preferred embodiment will be discussed, referring to the flowchart of Fig. 4. In this case, it is assumed that the file A is recorded in the memory 4 as shown in Fig. 3. Specifically, the file A is stored at the page addresses A0, rpA0, A2, A3 and A4.

The page addresses A0 to A7 are logical addresses recorded in the FAT 411 of the memory 4. In this preferred embodiment, however, the logical addresses recorded in the FAT 411 of the memory 4 are in a one-to-one correspondence with the physical addresses of the memory 4. Therefore, in this preferred embodiment, the file A is stored in discontinuous pages both as the logical addresses and as the physical addresses.

Now, discussion will be made on an operation of the application program for reading the file A. First, the application program executes an instruction for reading the file A (Step S1). In actual, this instruction is executed by the CPU 21.

Next, the FAT system accesses the memory 4 and refers to the FAT 411 and the replacement information table 412 recorded in the memory 4. With this operation, the chain information of the logical addresses (the chain information of the page addresses) at which the file A is stored and the replacement information of the defective area are acquired (Step S2). Specifically, the chain information indicating that the file A is stored at the logical addresses A0, A1, A2, A3 and A4 is acquired from the FAT 411 and the information indicating that the memory area of page address A1 is replaced with the area of page address rpA0 is acquired from the replacement information table 412.

The storage address information of the file A, which is acquired by the FAT system, is given to the driver. Specifically, the information indicating that the file A is stored in the address A0, rpA0, A2, A3 and A4 is given to the driver. The driver converts the storage logical addresses of the file A into physical addresses (Step S3). In order to perform this logical-physical address conversion, the host system 2 holds a correspondence table of page addresses.

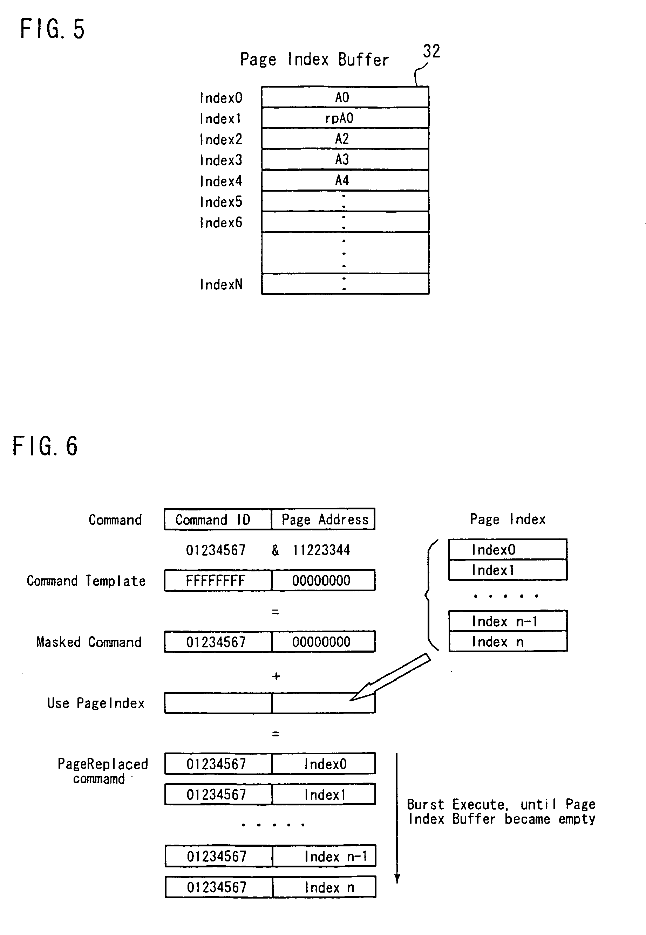

Receiving the storage physical addresses of the file A, the driver stores these physical addresses into the page index buffer 32 (Step S4). Fig. 5 is a view showing indexes of the file A, which are stored in the page index buffer 32. As shown in Fig. 5, the physical addresses A0, rpA0, A2, A3 and A4 are stored in memory areas corresponding to the indexes 0 to 4. Since physical addresses and logical addresses are in a one-to-one correspondence with each other in this preferred embodiment, as discussed earlier, addresses stored in the page index buffer 32 are also represented by the same reference signs A0, rpA0, A2, A3 and A4, for easy description.

The driver gives page number information of the file A to the page index transfer sequencer 34 (Step S5). In this case, since the file A is stored in five page areas of the memory 4, the page number information of "5" is given to the page index transfer sequencer 34. The page index transfer sequencer 34 has a buffer and stores the page number information of the file, which is received from the driver, into the buffer.

In addition, the driver sets a template of a command to the command template generator 33 (Step S6). In other words, the driver specifies a format of a read command for the memory 4. Specifically, a start bit position and the number of bits on the operator part, a start bit position and the number of bits on the address part and the like are set.

With these operations, a preparation for output of the read command is completed, and subsequently, the DMAC 22 outputs a DMA transfer command (Step S7). The DMA transfer command is a command for reading the file A, and this command only needs to specify the instruction word indicating a read command and does not need to specify a read address.

The read command outputted by the DMAC 22 is given to the command template generator 33 through the host interface 31. In the command template generator 33, the read command is masked by a command template, to clear the address part (Step S8).

Fig. 6 is a view showing replacement of a read command. In Fig. 6, "Command" represents a read command outputted from the DMAC 22. In this command, a code ("01234567" (hexadecimal)) indicating a read instruction (Read) is specified as "Command ID". Since the address part does not particularly need to be specified, it contains insignificant code (" 11223344" (hexadecimal)).

In Fig. 6, "Command Template" represents a command template generated in the command template generator 33. In this command template, all "F" (hexadecimal) is specified in the operator part of the command and all "0" (hexadecimal) is specified in the address part.

By masking the "Command" outputted from the DMAC 22 with the "Command Template", "Masked Command" is obtained. In other words, a logical product of the "Command" and the "Command Template" is the "Masked Command", and the address part thereof is cleared to all "0".

Next, the masked read command is outputted to the page index transfer sequencer 34. The page index transfer sequencer 34 acquires the page indexes of the file A from the page index buffer 32 on the basis of the page number information acquired from the driver (Step S9). In this case, since the page number information of "5" is acquired from the driver, the indexes of five areas, which are stored in the page index buffer 32, are acquired. Specifically, the physical addresses A0, rpA0, A2, A3 and A4 are acquired.

Then, the page index transfer sequencer 34 sets the indexes acquired from the page index buffer 32 to the address part of the masked read command one by one and outputs the page-replaced read commands to the memory 4 (Step S10). In this case, first, the page-replaced read command with the physical address A0 set in the address part is outputted to the memory 4, and subsequently the page-replaced read command with the physical address rpA0 set in the address part is outputted to the memory 4. In this manner, the page-replaced read commands with the physical addresses A2, A3 and A4 set in the address part, respectively, are sequentially outputted to the memory 4 in this order. In other words, receiving one read command for a file from the DMAC 22, the page index transfer sequencer 34 continuously outputs page-replaced read commands with all the page indexes which are received from the page index buffer 32.

With this operation, data stored at the physical addresses A0, rpA0, A2, A3 and A4 are sequentially outputted from the memory 4. These data are given to the host system 2 through the host interface 31. With these operations, the read operation for the file A is completed.

Thus, in this preferred embodiment, even if a file is stored at discontinuous logical addresses, it is possible to perform a DMA burst transfer, and this allows a speedup in file reading.

Further, by using the memory 4 and the information processing apparatus 1 of this preferred embodiment, it is possible to use the same ROM code among the perfect memory and the non-perfect memory. Specifically, the data stored in the FAT 411 and the data stored in the data area 42 of Fig. 3 are generated as a common ROM code. Then, if the file is stored in a perfect memory, the memory in which the ROM code is recorded serves as a program memory. On the other hand, if the file is stored in a non-perfect memory, the information recorded in the replacement information table 412 and that recorded in the reserve area 43 have only to be added to this common ROM code. With this operation, in a process for manufacturing a memory storing a game program, for example, it is possible to ensure an increase in productivity and reduction in cost.

In the above preferred embodiment, discussion has been made on the constitution in which the memory 4 is a non-perfect memory and replacement information of the defective area is written in the replacement information table 412. An example of such a constitution is a case where the information processing apparatus 1 is a game device and the memory 4 is an OTP (One Time Programmable) memory in which data can be written only one time, or the like. Specifically, a game program is stored in an OTP memory and this OTP memory is to be supplied for a user. Though an OTP memory may have a defective area as it is growing in capacity, a common ROM code has only to be produced as the game program. With this common ROM code, the game program can be stored in the OTP memory which is a non-perfect memory or in a perfect memory other than the OTP memory.

As an application of the present invention, it is possible to update a file by using the replacement information table 412. Though discussion has been made above on the case where the program memory is supplied for a user by using the OTP memory, some OTP memories allow information to be appended. In such a case, since the information in the FAT can not be revised, addition of files is impossible, but with respect to the files originally recorded in FAT, their contents can be substantially updated by adding information to the replacement information table 412 and the reserve area 43.

In other words, the present invention is effective when there is an area which needs to be replaced in a broad sense, not only when there is a defective area in the memory. If the area which needs to be replaced is a defective area, as discussed above, a maker has many merits such as an increase in productivity caused when the ROM code is generated. On the other hand, if the area which needs to be replaced is an area in which data to be updated is stored, a user has many merits since update of files becomes possible in the OTP memory which allows information to be appended.

In the above preferred embodiment, acquisition of page indexes and storage of the page indexes in the buffer are performed by software such as the file system and the driver and replacement of the address part of the command is performed by hardware, i.e., the page index transfer sequencer 34. In other words, a high-level function, not proper for hardware, is installed as part of the file system and a continuous read operation for pages which is a low-level function proper for hardware is installed as a sequencer and a buffer (register). This allows well-balanced load distribution among operations for software and those for hardware, and it is thereby possible to construct a high-performance and efficient system.

Though the DMA burst transfer is performed through replacement with page indexes in the above preferred embodiment, the present invention can be applied to a transfer by the CPU as well as the DMA transfer. Specifically, in the above preferred embodiment, there may be a case where instead of the DMAC 22, the CPU 21 generates a read command and the address part of the read command generated by the CPU 21 is replaced with the page indexes as shown in Fig. 6 or the like.

Further, the present invention is effective when the logical addresses of pages at which the file is stored are discontinuous. As discussed in the above preferred embodiment, however, if logical addresses and physical addresses are in a one-to-one correspondence with each other, the file is stored in pages also having discontinuous physical addresses. Therefore, the present invention can be applied to both cases where the logical addresses are discontinuous and where the physical addresses are discontinuous.

While the invention has been shown and described in detail, the foregoing description is in all aspects illustrative and not restrictive. It is therefore understood that numerous modifications and variations can be devised without departing from the scope of the invention.

## Claims

1. An information processing apparatus (1) for processing information stored in a memory device (4) in which a file is stored,
wherein said memory device (4) comprises
a first area (41) for storing file management information, and
a second area for storing substance data of a file, and
said second area comprises
a data area (42) for storing substance data of a file, and
a replacement area (43) used as an alternative storage area for substance data if said data area (42) has an area which needs to be replaced, and
said file management information is information read out by a file system which accesses said memory device (4),
said information processing apparatus (1) comprising:
a host system (2) for processing information stored in said memory device (4); and
a controller (3) for controlling access to said memory device (4),
wherein said host system (2) includes said file system used for management of information stored in said memory device (4),
**characterized in that**
said file management information includes chain information (411) on a file and correspondence information (412) between an area which needs to be replaced and said replacement area; and
said controller (3) comprises
a page index buffer (32) for storing page indexes of a file, which are acquired from said file management information based on said chain information and said correspondence information, and
a replacement element (34), receiving a read command for said file from said host system (2), for sequentially replacing an address part of said read command with page indexes stored in said page index buffer (32) to continuously transfer page-replaced read commands to said memory device (4).

2. The information processing apparatus according to claim 1, wherein
said file management information includes chain information (411) on a file in a case where there is no area that needs to be replaced.

3. The information processing apparatus according to claim 1, wherein
said file management information includes chain information (411) on a file after said area which needs to be replaced is replaced with said replacement area (43).

4. The information processing apparatus according to any one of claims 1 to 3, wherein
said memory device (4) is a semiconductor memory and said area which needs to be replaced is replaced with said replacement area (43) on a page-by-page basis.

5. The information processing apparatus according to any one of claims 1 to 4, wherein
said area which needs to be replaced includes a defective area in said data area (42).

6. The information processing apparatus according to any one of claims 1 to 4, wherein
said area which needs to be replaced includes an area in which data to be updated is recorded, and update of data is performed by recording updated data in said replacement area (43).

7. The information processing apparatus according to any one of claims 1 to 6, wherein
page indexes of said file stored in said memory device (4) are read out by said file system,
the page indexes read out are stored in said page index buffer (32) by software, and
said replacement element (34) is formed of hardware.

8. The information processing apparatus according to any one of claims 1 to 7, wherein
said host system (2) includes a DMA controller (22), and
a read command for said file, which is outputted from said host system (2), is controlled by said DMA controller (22) and page-replaced read commands obtained by sequentially replacing an address part of said read command with page indexes in said replacement element (34) are burst transferred.

9. The information processing apparatus according to claim 8, wherein
a discontinuous file stored at discontinuous page addresses due to presence of an area which needs to be replaced is recorded in said memory device (4),
discontinuous page indexes of said discontinuous file are stored in said page index buffer (32), and
said replacement element (34) replaces an address part of a read command with discontinuous page indexes and said DMA controller (22) thereby reads out said discontinuous file with one burst transfer.

## Patentansprüche

1. Informationsverarbeitungsvorrichtung (1) zum Verarbeiten von Informationen, die in einer Speichervorrichtung (4), in der eine Datei gespeichert ist, gespeichert sind,
wobei die Speichervorrichtung (4) aufweist:
einen ersten Bereich (41) zum Speichern von Dateiverwaltungsinformationen, und
einen zweiten Bereich zum Speichern von Substanzdaten einer Datei, und
wobei der zweite Bereich aufweist:
einen Datenbereich (42) zum Speichern von Substanzdaten einer Datei, und
einen Ersetzungsbereich (43), der als ein alternativer Speicherbereich für Substanzdaten verwendet wird, wenn der Datenbereich (42) einen Bereich aufweist, der ersetzt werden muss, und
wobei die Dateiverwaltungsinformationen Informationen sind, die von einem Dateisystem, das auf die Speichervorrichtung (4) zugreift, ausgelesen werden,
wobei die Informationsverarbeitungsvorrichtung (1) aufweist:
ein Host-System (2) zum Verarbeiten von Informationen, die in der Speichervorrichtung (4) gespeichert sind; und
eine Steuerung (3) zum Steuern des Zugriffs auf die Speichervorrichtung (4),
wobei das Host-System (2) das Dateisystem, das für die Verwaltung von Informationen, die in der Speichervorrichtung (4) gespeichert sind, verwendet wird, enthält,
**dadurch gekennzeichnet, dass**
die Dateiverwaltungsinformationen Verkettungsinformationen (411) einer Datei und Entsprechungsinformationen (412) zwischen einem Bereich, der ersetzt werden muss, und dem Ersetzungsbereich enthalten; und
die Steuerung (3) aufweist:
einen Seitenindexpuffer (32) zum Speichern von Seitenindizes einer Datei, die von den Dateiverwaltungsinformationen auf der Grundlage der Verkettungsinformationen und der Entsprechungsinformationen erlangt werden, und
ein Ersetzungselement (34), das einen Lesebefehl für die Datei von dem Host-System (2) empfängt, zum aufeinanderfolgenden Ersetzen eines Adressteils des Lesebefehls durch Seitenindizes, die in dem Seitenindexpuffer (32) gespeichert sind, um kontinuierlich seitenersetzte Lesebefehle an die Speichervorrichtung (4) zu übertragen.

2. Informationsverarbeitungsvorrichtung nach Anspruch 1, wobei die Dateiverwaltungsinformationen Verkettungsinformationen (411) einer Datei in einem Fall enthalten, in dem kein Bereich ersetzt werden muss.

3. Informationsverarbeitungsvorrichtung nach Anspruch 1, wobei die Dateiverwaltungsinformationen Verkettungsinformationen (411) einer Datei enthalten, nachdem der Bereich, der ersetzt werden muss, durch den Ersetzungsbereich (43) ersetzt ist.

4. Informationsverarbeitungsvorrichtung nach einem der Ansprüche 1 bis 3, wobei die Speichervorrichtung (4) ein Halbleiterspeicher ist und der Bereich, der ersetzt werden muss, durch den Ersetzungsbereich (43) auf einer Seite-um-Seite-Basis ersetzt wird.

5. Informationsverarbeitungsvorrichtung nach einem der Ansprüche 1 bis 4, wobei der Bereich, der ersetzt werden muss, einen fehlerhaften Bereich in dem Datenbereich (42) enthält.

6. Informationsverarbeitungsvorrichtung nach einem der Ansprüche 1 bis 4, wobei
der Bereich, der ersetzt werden muss, einen Bereich enthält, in dem zu erneuernde Daten aufgezeichnet werden, und
das Erneuern der Daten durch Aufzeichnen von erneuerten Daten in dem Ersetzungsbereich (43) durchgeführt wird.

7. Informationsverarbeitungsvorrichtung nach einem der Ansprüche 1 bis 6, wobei
Seitenindizes der Datei, die in der Speichervorrichtung (4) gespeichert ist, von dem Dateisystem ausgelesen werden,
die Seitenindizes, die ausgelesen werden, in dem Seitenindexpuffer (32) mittels Software gespeichert werden,
das Ersetzungselement (34) aus Hardware ausgebildet ist.

8. Informationsverarbeitungsvorrichtung nach einem der Ansprüche 1 bis 7, wobei
das Host-System (2) eine DMA-Steuerung (22) enthält, und
ein Lesebefehl für die Datei, der von dem Host-System (2) ausgegeben wird, von der DMA-Steuerung (22) gesteuert wird und seitenersetzte Lesebefehle, die durch aufeinanderfolgendes Ersetzen eines Adressteils des Lesebefehls durch Seitenindizes in dem Ersetzungselement (34) erhalten werden, mittels Burst übertragen werden.

9. Informationsverarbeitungsvorrichtung nach Anspruch 8, wobei
eine diskontinuierliche Datei, die aufgrund des Vorhandenseins eines Bereiches, der ersetzt werden muss, an diskontinuierlichen Seitenadressen gespeichert wird, in der Speichervorrichtung (4) aufgezeichnet wird,
diskontinuierliche Seitenindizes der diskontinuierlichen Datei in dem Seitenindexpuffer (32) gespeichert werden, und
das Ersetzungselement (34) einen Adressteil eines Lesebefehls durch diskontinuierliche Seitenindizes ersetzt und die DMA-Steuerung (22) **dadurch** die diskontinuierliche Datei mittels einer Burst-Übertragung ausliest.

## Revendications

1. Dispositif de traitement d'informations (1) pour traiter des informations mémorisées dans un dispositif de mémoire (4) dans lequel un fichier est mémorisé,
dans lequel ledit dispositif de mémoire (4) comprend :
une première zone (41) pour mémoriser des informations de gestion de fichier ; et
une deuxième zone pour mémoriser des données de substance d'un fichier, et
ladite deuxième zone comprend :
une zone de données (42) pour mémoriser des données de substance d'un fichier ; et
une zone de remplacement (43) utilisée en tant qu'autre zone de mémorisation pour des données de substance si ladite zone de données (42) comporte une zone qui doit être remplacée, et
lesdites informations de gestion de fichier sont des informations lues par un système de fichiers qui accède audit dispositif de mémoire (4),
ledit dispositif de traitement d'informations (1) comprenant :
un système hôte (2) pour traiter des informations mémorisées dans ledit dispositif de mémoire (4) ; et
un contrôleur (3) pour contrôler l'accès audit dispositif de mémoire (4),
dans lequel ledit système hôte (2) comprend ledit système de fichiers utilisé pour la gestion d'informations mémorisées dans ledit dispositif de mémoire (4),
**caractérisé en ce que**
lesdites informations de gestion de fichier comprennent des informations de chaîne (411) concernant un fichier et des informations de correspondance (412) entre une zone qui doit être remplacée et ladite zone de remplacement ; et
ledit contrôleur (3) comprend :
une mémoire tampon d'index de pages (32) pour mémoriser les index de pages d'un fichier, qui sont obtenus à partir des informations de gestion de fichier sur la base desdites informations de chaîne et desdites informations de correspondance ; et
un élément de remplacement (34), recevant une commande de lecture pour ledit fichier dudit système hôte (2), pour remplacer séquentiellement une partie d'adresse de ladite commande de lecture par des index de pages mémorisés dans ladite mémoire tampon d'index de pages (32) pour transférer continuellement des commandes de lecture à index de pages, audit dispositif de mémoire (4).

2. Dispositif de traitement d'informations selon la revendication 1, dans lequel
lesdites informations de gestion de fichier comprennent des informations de chaîne (411) concernant un fichier dans un cas où il n'y a aucune zone qui doit être remplacée.

3. Dispositif de traitement d'informations selon la revendication 1, dans lequel
lesdites informations de gestion de fichier comprennent des informations de chaîne (411) concernant un fichier après que ladite zone qui doit être remplacée a été remplacée par ladite zone de remplacement (43).

4. Dispositif de traitement d'informations selon l'une quelconque des revendications 1 à 3, dans lequel
ledit dispositif de mémoire (4) est une mémoire à semi-conducteurs et ladite zone qui doit être remplacée est remplacée par ladite zone de remplacement (43) sur une base page par page.

5. Dispositif de traitement d'informations selon l'une quelconque des revendications 1 à 4, dans lequel
ladite zone qui doit être remplacée comprend une zone défectueuse dans ladite zone de données (42).

6. Dispositif de traitement d'informations selon l'une quelconque des revendications 1 à 4, dans lequel
ladite zone qui doit être remplacée comprend une zone dans laquelle des données à mettre à jour sont enregistrées, et
la mise à jour de données est effectuée en enregistrant des données mises à jour dans ladite zone de remplacement (43) .

7. Dispositif de traitement d'informations selon l'une quelconque des revendications 1 à 6, dans lequel
des index de pages dudit fichier mémorisé dans ledit dispositif de mémoire (4) sont lus par ledit système de fichiers,
les index de pages lus sont mémorisés dans ladite mémoire tampon d'index de pages (32) par un logiciel, et
ledit élément de remplacement (34) est constitué d'un matériel.

8. Dispositif de traitement d'informations selon l'une quelconque des revendications 1 à 7, dans lequel
ledit système hôte (2) comprend un contrôleur DMA (22), et
une commande de lecture pour ledit fichier, qui est délivrée par ledit système hôte (2), est contrôlée par ledit contrôleur DMA (22) et des commandes de lecture à index de pages obtenues en remplaçant séquentiellement une partie d'adresse de ladite commande de lecture par des index de pages dans ledit élément de remplacement (3.4) sont transférées par salves.

9. Dispositif de traitement d'informations selon la revendication 8, dans lequel
un fichier discontinu mémorisé à des adresses de pages discontinues du fait de la présence d'une zone qui doit être remplacée est enregistré dans ledit dispositif de mémoire (4),
des index de pages discontinus dudit fichier discontinu sont mémorisés dans ladite mémoire tampon d'index de pages (32), et
ledit élément de remplacement (34) remplace une partie d'adresse d'une commande de lecture par des index de pages discontinus et ledit contrôleur DMA (22) lit de ce fait ledit fichier discontinu avec un transfert par salves.
